(19)

Europäisches
Patentamt
European
Patent Office
Office européen
des brevets

(11) **EP 1 806 390 B1**

(12) **EUROPEAN PATENT SPECIFICATION**

(45) Date of publication and mention
of the grant of the patent:
**02.03.2011 Bulletin 2011/09**

(21) Application number: **05785839.1**

(22) Date of filing: **16.09.2005**

(51) Int Cl.:
***C09K 11/64*** (2006.01)     ***C09K 11/08*** (2006.01)
***H01L 33/00*** (2010.01)

(86) International application number:
**PCT/JP2005/017543**

(87) International publication number:
**WO 2006/033417 (30.03.2006 Gazette 2006/13)**

(54) **PHOSPHOR AND METHOD FOR PRODUCTION THEREOF, AND LUMINOUS UTENSIL**

LEUCHTSTOFF UND HERSTELLUNGSVERFAHREN SOWIE LEUCHTENDES UTENSIL

PHOSPHORE ET PROCÉDÉ DE FABRICATION DE CELUI-CI ET USTENSILE LUMINEUX

(84) Designated Contracting States:
**DE FR GB NL**

(30) Priority: **22.09.2004 JP 2004274782**

(43) Date of publication of application:
**11.07.2007 Bulletin 2007/28**

(73) Proprietor: **National Institute for Materials Science
Tsukuba-shi,
Ibaraki 305-0047 (JP)**

(72) Inventor: **Hirosaki,Naoto
c/o National Institute for Materials Science
Tsukuba-shi,
Ibaraki, 305-0047 (JP)**

(74) Representative: **Vossius & Partner
Siebertstrasse 4
81675 München (DE)**

(56) References cited:
**EP-A1- 0 155 047      EP-A2- 1 296 376
JP-A- 2003 206 481**

**Description**

TECHNICAL FIELD

The present invention relates to a phosphor mainly including an inorganic compound and a production method and usage thereof. More particularly, the usage relates to a light emitting instrument for a lighting instrument and for an image displaying apparatus, utilizing the nature possessed by the phosphor, i.e., the property to emit fluorescence at longer wavelengths at 570 nm or longer.

BACKGROUND ART

Phosphors have been utilized for vacuum fluorescent displays (VFD), field emission displays (FED), plasma display panels (PDP), cathode ray tubes (CRT), white light emitting diodes (LED), and the like.

In all these usages, it is required to supply an energy to an applicable phosphor to thereby excite it so as to cause it to emit light, and the phosphor is excited by an excitation source having a higher energy such as vacuum ultraviolet light, ultraviolet light, electron beam, blue light, or the like, such that the phosphor is caused to emit visible light. However, since phosphors are exposed to the aforementioned excitation sources to resultingly cause a problem of deteriorated luminance, thereby necessitating a phosphor which is free of luminance deterioration.

As such, there has been proposed a sialon phosphor as a phosphor exhibiting less luminance deterioration, instead of the conventional silicate phosphor, phosphate phosphor, aluminate phosphor, sulfide phosphor, and the like.

The sialon phosphor is produced by a production process as generally described below. Firstly, there are mutually mixed silicon nitride ($Si_3N_4$), aluminum nitride (AIN), calcium carbonate ($CaCO_3$), and europium oxide ($Eu_2O_3$) at a predetermined molar ratio, followed by holding for 1 hour at a temperature of 1,700°C in nitrogen at 1atm (0.1 MPa), and firing by hot pressing for production (see patent-related reference 1, for example).

It has been reported that $\alpha$-sialon obtained by the process and activated by Eu ion is established into a phosphor which is excited by blue light at 450 to 500 nm and caused to emit yellow light at 550 to 600 nm. However, there have been demanded not only the phosphor which emits yellow light but also phosphors which emit orange light and red light, respectively, for usages such as white LED and plasma display each having an ultraviolet LED as an excitation source. Further, there have been demanded phosphors which emit orange light, red light, and the like, respectively, in a white LED having a blue LED as an excitation source, for an improved color rendering property.

As a phosphor which emits red light, there has been reported an inorganic substance ($Ba_{2-x}Eu_xSi_5N_8$; where x=0.14 to 1.16) obtained by activating a $Ba_2Si_5N_8$ crystal with Eu, in a scientific literature (see patent-unrelated reference 1) prior to filing of the present application. There has been further reported a phosphor including, as a host material, a ternary nitride $M_xSi_yN_z$ (M= Ca, Sr, Ba, Zn; where x, y, and z take various values, respectively) of alkali metals and silicon at various compositions, in the second chapter of a publication "On new rare-earth doped M-Si-Al-O-N materials" (see patent-unrelated reference 2).

Similarly, there has been reported $M_xSi_yN_z$ (M= Ca, Sr, Ba, Zn; where z=2/3x+4/3y), in U.S. Patent No. 6,682,663 (patent-related reference 2).

As nitride phosphors, and oxynitride phosphors different from the above phosphors, there have been described phosphors including, as host crystals, $MSi_3N_5$, $M_2Si_4N_7$, $M_4Si_6N_{11}$, $M_9Si_{11}N_{23}$, $M1_6Si_{15}O_6N_{32}$, $M_{13}Si_{18}Al_{12}O_{18}N_{36}$, $MSi_5Al_2ON_9$, and $M_3Si_5AlON_{10}$ (where M is Ba, Ca, Sr, or rare earth element) activated with Eu, Ce, or the like in JP-A-2003-206481 (patent-related reference 3) and U.S. Patent No. 6,670,748 (patent-related reference 4), and there have been described therein a phosphor which emits red light and an LED lighting unit utilizing the phosphor.

Among them, $SrSiAl_2O_3N2$: $Eu^{2+}$ and $Sr_2Si_4AlON_7$: $2u^{2+}$ have been described as compounds including Sr. Further, there has been reported a phosphor obtained by activating an $Sr_2Si_5N_8$ or $SrSi_7N_{10}$ crystal with Ce, in JP-A-2002-322474 (patent-related reference 5).

In JP-A-2003-321675(patent-related reference 6), there have been found a description of a phosphor $L_xM_yN_{(2/3x-4/3y)}$:Z (L is a divalent element such as Ca, Sr, Ba, or the like, and M is a tetravalent element such as Si, Ge, or the like, and Z is an activator such as Eu), and a description that addition of a small amount of Al brings about an effect of restricting afterglow.

Further, it has been known that a combination of the phosphor with a blue LED provides a light emitting apparatus for emitting warm color based and slightly reddish white light. In turn, there has been disclosed a phosphor configured with various L elements, M elements, and Z elements, as an $L_xM_yN_{(2/3x-4/3y)}$ : Z phosphor, in JP-A-2003-277746 (patent-related reference 7) . Meanwhile, although JP-A-2004-10786 (patent-related reference 8) has described a wide variety of combinations concerning L-M-N:Eu, Z types, it has failed to show an effect of improved emission characteristics in case of adopting specific compositions or crystal phases as host materials.

Although the phosphors represented by those of the aforementioned patent-related references 2 and 5 through 8 have been reported as ones including various different crystal phases as host materials such that nitrides of divalent elements and tetravalent elements are included as host crystals while providing known phosphors for emitting red light, emission luminances of red light have been insufficient insofar as based on excitation by blue visible light. Further, the phosphors have been chemically unstable depending on compositions, thereby exhibiting a problem of durability.

Furthermore, $SrSiAl_2O_3N_2$: $Eu^{2+}$ and $Sr_2Si_4AlON_7$: $Eu^{2+}$ shown in the patent-related references 3 and 4 have been insufficient in emission luminance.

Moreover, as the related art of lighting apparatus, there has been known a white light emitting diode based on a combination of a blue light emitting diode element with a blue-light absorbing/yellow-light emitting phosphor, which has been practiced in various lighting usages.

Representative examples thereof include JP-2900928 (patent-related reference 9) entitled "Light Emitting Diode", JP-2927279 (patent-related reference 10) entitled "Light Emitting Diode", JP-3364229 (patent-related reference 11) entitled "Casting Material for Wavelength Conversion, Production Method Thereof, and Light Emitting Element", and the like.

The phosphors, which are particularly frequently utilized in these light emitting diodes, are yttrium/aluminum/garnet based phosphors represented by a general formula $(Y, Gd)_3(Al, Ga)_5O_{12}:Ce^{3+}$.

However, the white light emitting diode comprising the blue light emitting diode element and the yttrium/aluminum/garnet based phosphor has a feature to emit bluish white light due to lack of a red component, thereby problematically exhibiting deviation in a color rendering property.

Under such circumstances, there has been investigated a white light emitting diode including two kinds of mixed and dispersed phosphors, such that a red component lacking in case of a yttrium/aluminum/garnet based phosphor is compensated for by an additional red-aimed phosphor.

Examples of such light emitting diodes include those described in JP-A-10-163535 (patent-related reference 12) entitled "White Light Emitting Element", JP-A-2003-321675 (patent-related reference 6) entitled "Nitride Phosphor and Production Method Thereof",and the like.

However, there have been still left problems to be improved concerning color rendering property even by these inventions, thereby necessitating a light emitting diode for solving such a problem. Further, the red-aimed phosphor described in JP-A-10-163535 (the patent-related reference 12) includes cadmium, thereby exhibiting a problem of environmental pollution.

Contrary, although the red-light emitting phosphors including $Ca_{1.97}Si_5N_8$: $Eu_{0.03}$ described in JP-A-2003-321675 (the patent-related reference 6) as a representative example do not include cadmium, the phosphors are low in luminance, thereby still necessitating a further improvement of emission intensities thereof.

Referenced Literature/Publication:

Patent-unrelated reference 1: H. A. Hoppe, and four others, "Journal of Physics and Chemistry of Solids", 2000, No. 61, pp. 2001-2006
Parent-unrelated reference 2: "On new rare-earth doped M-Si-Al-O-N meterials", written by J. W. H. van Krevel, TU Eindhoven 2000, ISBN 90-386-2711-4
Patent-related reference 1: JP-A-2002-363554
Patent-related reference 2: U.S. Patent No. 6,682,663
Patent-related reference 3: JP-A-2003-206481
Patent-related reference 4: U.S. Patent No. 6,670,748
Patent-related reference 5: JP-A-2002-322474
Patent-related reference 6: JP-A-2003-321675
Patent-related reference 7: JP-A-2003-277746
Patent-related reference 8: JP-A-2004-10786
Patent-related reference 9: JP-2900928
Patent-related reference 10: JP-2927279
Patent-related reference 11: JP-3364229
Patent-related reference 12: JP-A-10-163535

DISCLOSURE OF THE INVENTION

Problem to be solved by the Invention

The present invention intends to satisfy such a demand, and has an object to provide a chemically stabilized inorganic phosphor having an orange or red emission characteristic at a higher luminance. It is another object of the present invention to provide a light emitting instrument utilizing such a phosphor, for a lighting instrument excellent in color rendering property and for an image displaying apparatus excellent in durability.

Means for solving the Problem

Under these circumstances, the present inventors have specifically investigated phosphors including, as host materials, inorganic oxynitride crystals including (i) divalent alkaline earth elements such as Ca, Sr; (ii) Al, and (iii) Si, all as main metallic elements, and have found that the phosphors of the present inventors including, as host materials, inorganic crystals having specific compositions, respectively, emit orange or red light at wavelengths longer than those by the conventional rare-earth activated sialon phosphors, and exhibit higher luminances and are excellent in chemical stability than those provided by the conventionally reported red-aimed phosphor including nitrides or oxynitrides as host crystals.

Namely, the present inventors have earnestly and repeatedly investigated inorganic compounds mainly including oxynitrides containing: an M element (M is one kind or two or more kinds of element(s) selected from Mn, Ce, Nd, Sm, Eu, Tb, Dy, Ho, Er, Tm, and Yb) to be matured into a light emitting ion; a divalent A element (A is one kind or two or more kinds of element(s) selected from Mg, Ca, Sr, and Ba); Si; Al; nitrogen; and oxygen; and have found that crystal phases having specific compositions are established into phosphors, which emit orange or red light at wavelengths of 570 nm or longer, and which are excellent in chemical stability.

Further, the present inventors have found that adoption of this phosphor allows for obtainment of a white light emitting diode having a higher light-emission efficiency and being excellent in color rendering property with a rich red component, and an image displaying apparatus for exhibiting brilliant red color.

The present inventors have also found that oxynitrides including, as main constituent metallic elements, Al in addition to divalent and tetravalent elements, allow for achievement of red emission at a luminance which has never been provided up to now, unlike the ternary nitrides including divalent and tetravalent elements as represented by the conventionally reported $L_xM_yN_{(2/3x+4/3y)}$. Further, the present invention resides in a novel phosphor including, as a host material, a crystal having a composition and a crystal structure which are fully different from those of $M_{13}Si_{18}Al_{12}O_{18}N_{36}$, $MSi_5Al_2ON_g$, $M_3Si_5AlON_{10}$ (M is Ca, Ba, Sr, or the like) conventionally reported in the patent-related reference 3, and the like, and the sialon such as $Ca_{1.47}Eu_{0.03}Si_9Al_3N_{16}$ described in the eleventh chapter of the patent-unrelated reference 2. Furthermore, unlike the crystal including Al on the order of several hundreds ppm described in the patent-related reference 6, the phosphors of the present invention include, as host materials, host crystals including Al as main constituent elements thereof.

Generally, phosphors including inorganic host crystals activated with Mn or rare earth element as an emission center element M, exhibit light emission colors and luminances which vary depending on electronic states around the M element. For example, it has been reported that change of host crystals in phosphors each including divalent Eu as an emission center leads to emission in blue, green, yellow, or red color. Namely, even phosphors having apparently similar compositions exhibit fully different light emission colors and luminances when crystal structures of the host materials or atom positions in the crystal structures for introducing M thereinto are changed, so that such phosphors are regarded as ones different from one another. The present invention has devised, as host crystals, divalent-trivalent-tetravalent multi-component oxynitrides different from the conventional ternary nitrides of divalent and tetravalent elements, and devised, as host materials, crystal fully different from the conventionally reported compositions of sialons, and any phosphors including such crystals as host materials have been never reported in the conventional. Moreover, the phosphors including the compositions of the present invention as host materials, are ones superior to those phosphors including the conventional crystals as host materials, in that the phosphors of the present invention exhibit red light emission at higher luminance.

The present inventors have earnestly and repetitively conducted investigation in view of the above-described actual situation, and have succeeded in providing phosphors which exhibit emission phenomena at higher luminances over specific wavelength ranges, respectively, by achieving configurations recited in the following items (1) through (14). Further, the present inventors have succeeded in producing phosphors having excellent emission characteristics, by adopting the methods of items (15) through (24) . Moreover, the present inventors have also succeeded in providing a lighting instrument and an image displaying apparatus having excellent properties by using the phosphor and achieving configurations recited in items (25) through (34), and the above configurations are recited in the following items (1) through (34).

(1) A phosphor, characterized in that the phosphor includes, as a main component, an inorganic compound comprising:

a crystal represented by $A_2Si_{5-x}Al_xO_xN_{8-x}$ (A is a mixture of one kind or two or more kinds of element(s) selected from Mg, Ca, Sr, and 3a; and x is a value between 0.05 inclusive and 0.8 inclusive); and

a metallic element M (M is one kind or two or more kinds of element(s) selected from Mn, Ce, Nd, Sm, Eu, Tb, Dy, Ho, Er, Tm, and Yb) dissolved, in a solid state, in the crystal.

(2) The phosphor of item (1), characterized in that x is a value between 0.05 inclusive and 0.5 inclusive.

(3) The phosphor of item (1)or (2), characterized in that the inorganic compound comprises a solid solution crystal represented by $A_{2-y}Si_{5-x}Al_xO_xN_{8-x}:M_y$, and y is a value in a range of $0.001 \leq 0 \leq 0.5$.

(4) The phosphor of any one of items (1) through (3), characterized in that the phosphor includes at least Eu in the metallic element M.

(5) The phosphor of any one of items (1) through (4), characterized in that the metallic element M is Eu and the metallic element A is Sr.

(6) The phosphor of any one of items (1) through (4), characterized in that the metallic element M is Eu and the metallic element A is Ca.

(7) The phosphor of any one of items (1) through (4), characterized in that the inorganic compound comprises a solid solution crystal represented by $Sr_aCa_bSi_{5-x}Al_xO_xN_{x-8}:Eu_y$, and values of "a" and "b" are within ranges, respectively, defined by:

$$a+b=2-y,$$

and

$$0.2 \leq a/(a+b) \leq 1.8.$$

(8) The phosphor of any one of items (1) through (7), characterized in that the inorganic compound is a powder having an averaged particle size between 0.1 $\mu$m inclusive and 20 $\mu$m inclusive.

(9) A phosphor characterized in that the phosphor is constituted of a mixture of the inorganic compound of any one of items (1) through (8) and an additional crystal phase or amorphous phase; and

that the inorganic compound of any one of items (1) through (8) is included at a content of 10 mass% or more.

(10) The phosphor of item (9), characterized in that the content of inorganic compound of any one of items (1) through (8) is 50 mass% or more.

(11) The phosphor of item (9) or (10), characterized in that the additional crystal phase or amorphous phase is an inorganic substance having electroconductivity.

(12) The phosphor of item (11), characterized in that the inorganic substance having electroconductivity is oxide, oxynitride, nitride, or a mixture thereof including one kind or two or more kinds of element(s) selected from Zn, Ga, In, and Sn.

(13) The phosphor of any one of items (1) through (12), characterized in that the phosphor emits orange or red fluorescence at a wavelength between 570 nm inclusive and 700 nm inclusive, by irradiation of an excitation source comprising ultraviolet light, visible light, or electron beam having a wavelength between 100 nm inclusive and 550 nm inclusive.

(14) The phosphor of item (13), characterized in that the phosphor emits fluorescence having (x, y) values on CIE chromaticity coordinates satisfying a condition of $0.4 \leq < \leq 0.7$, upon irradiation by the excitation source.

(15) A production method of the phosphor of any one of items (1) through (14), characterized in that the method comprises the step of:

firing a starting material mixture in a nitrogen atmosphere at a pressure between 0.1 MPa inclusive and 100 MPa inclusive at a temperature range between 1,200°C inclusive and 2,200°C inclusive,

wherein the starting material mixture is a mixture of metallic compounds, and is capable of constituting a composition comprising M, A, Si, Al, O, and N (M is one kind or two or more kinds of element (s) selected from Mn, Ce, Nd, Sm, Eu, Tb, Dy, Ho, Er, Tm, and Yb; and A is one kind or two or more kinds of element(s) selected from Mg, Ca, Sr, and Ba).

(16) The production method of the phosphor of item (15), characterized in that the metallic compound mixture is a mixture of: a metal, oxide, carbonate, nitride, fluoride, chloride, or oxynitride of M; a metal, oxide, carbonate, nitride, fluoride, chloride, or oxynitride of A; silicon nitride; and aluminum nitride.

(17) The production method of the phosphor of item (15) or (16), characterized in that the method further comprises the step of:

firing the metallic compounds each in a form of powder or aggregation, after filling the metallic compounds in a container in a state where the metallic compounds are held at a filling ratio exhibiting a relative bulk density of 40% or less.

(18) The production method of the phosphor of item (17), characterized in that the container is made of boron nitride.
(19) The production method of the phosphor of any one of items (15) through (18), characterized in that the sintering step is conducted not by means of hot-press, but exclusively by means of ordinary pressure sintering or gas pressure sintering.
(20) The production method of the phosphor of any one of items (15) through (19), characterized in that the method further comprises the step of:

adjusting the synthesized phosphor powder in granularity, to cause the same to have an averaged particle size between 50 nm inclusive and 20 $\mu$m inclusive, by a single or multiple procedures selected from pulverization, classification, and acid treatment.

(21) The production method of the phosphor of any one of items (15) through (20), characterized in that the method further comprises the step of:

heat treating the phosphor powder after firing, the phosphor powder after pulverization treatment, or the phosphor powder after granularity adjustment, at a temperature between 1,000°C inclusive and the firing temperature inclusive.

(22) The production method of the phosphor of any one of items (15) through (21), characterized in that the method further comprises the step of:

washing the product after firing by a solvent comprising water or an acidic water solution, to thereby decrease contents of a glass phase, second phase, or impurity phase included in the product.

(23) The production method of the phosphor of item (22), characterized in that the acid comprises a single or a combination of sulfuric acid, hydrochloric acid, nitric acid, hydrofluoric acid, and organic acids.
(24) The production method of the phosphor of item (22) or (23), characterized in that the acid is a mixture of hydrofluoric acid and sulfuric acid.
(25) A lighting instrument constituted of a light-emitting source and a phosphor, characterized in that the phosphor of at least one of items (1) through (14) is used.
(26) The lighting instrument of item (25), characterized in that the light-emitting source is an LED for emitting light at a wavelength of 330 to 500 nm.
(27) The lighting instrument of item (25) or (26), characterized in that the light-emitting source is an LED for emitting light at a wavelength between 330 and 420 nm; and
that the constituent phosphor is provided by adopting: the phosphor of any one of items (1) through (14); a blue-aimed phosphor having an emission peak at a wavelength between 420 nm inclusive and 500 nm inclusive by pump light between 330 and 420 nm; and a green-aimed phosphor having an emission peak at a wavelength between 500 nm inclusive and 570 nm inclusive by pump light between 330 and 420 nm; so that the constituent phosphor emits white light mixedly including red light, green light, and blue light.
(28) The lighting instrument of item (25) or (26), characterized in that the light-emitting source is an LED for emitting light at a wavelength between 420 and 500 nm; and
that the constituent phosphor is provided by adopting: the phosphor of any one of items (1) through (14) ; and a green-aimed phosphor having an emission peak at a wavelength between 500 nm inclusive and 570 nm inclusive by pump light between 420 and 500 nm; so that the constituent phosphor emits white light.
(29) The lighting instrument of item (25) or (26), characterized in that the light-emitting source is an LED for emitting light at a wavelength between 420 and 500 nm; and
that the constituent phosphor is provided by adopting: the phosphor of any one of items (1) through (14); and a yellow-aimed phosphor having an emission peak at a wavelength between 550 nm inclusive and 600 nm inclusive by pump light between 420 and 500 nm; so that the constituent phosphor emits white light.
(30) The lighting instrument of item (29), characterized in that the yellow-aimed phosphor is Ca-$\alpha$-sialon including Eu dissolved therein in a solid state.
(31) The lighting instrument of item (27) or (28), characterized in that the green-aimed phosphor is $\beta$-sialon including

Eu dissolved therein in a solid state.

(32) An image displaying apparatus constituted of an excitation source and a phosphor, characterized in that the phosphor of at least one of items (1) through (14) is used.

(33) The image displaying apparatus of item (32), characterized in that the excitation source is electron beam, electric field, vacuum ultraviolet light, or ultraviolet light.

(34) The image displaying apparatus of item (32) or (33), characterized in that the image displaying apparatus is a vacuum fluorescent display (VFD), field emission display (FED), plasma display panel (PDP), or cathode ray tube (CRT).

Effect of the Invention

The phosphors of the present invention each include, as a main component: a multi-component oxynitride including a divalent alkaline earth element, Al, Si, oxygen, and nitrogen; so that the phosphors of the present invention exhibit emission at longer wavelengths than those by conventional sialon phosphors, oxynitride phosphors, and the like, and are excellent as phosphors for emission in orange, red, and the like. Further, the phosphors of the present invention serve as useful ones to be preferably used for VFD, FED, PDF, CRT, white LED, and the like without luminance deterioration even when exposed to excitation sources.

BRIEF DESCRIPTION OF THE DRAWINGS

FIG. 1 is an X-ray diffractometry chart of a phosphor (Example 1).
FIG. 2 is an X-ray diffractometry chart of a phosphor (Comparative Example 2).
FIG. 3 is a graph showing an emission spectrum and an excitation spectrum of a phosphor (Example 1).
FIG. 4 is a graph showing an emission spectrum and an excitation spectrum of β-sialon:Eu green-aimed phosphor.
FIG. 5 is a schematic view of a lighting instrument (LED lighting instrument) according to the present invention.
FIG. 6 is a graph showing an emission spectrum of the lighting instrument.
FIG. 7 is a schematic view of a lighting instrument (LED lighting instrument) according to the present invention.
FIG. 8 is a schematic view of an image displaying apparatus (plasma display panel) according to the present invention.

Explanation of reference numerals

| | |
|---|---|
| 1 | bullet type light emitting diode lamp |
| 2, 3 | lead wire |
| 4 | light emitting diode element |
| 5 | bonding wire |
| 6, 8 | resin |
| 7 | phosphor |
| 11 | chip-type white light emitting diode lamp to be mounted on substrate |
| 12, 13 | lead wire |
| 14 | light emitting diode element |
| 15 | bonding wire |
| 16, 18 | resin |
| 17 | phosphor |
| 19 | alumina ceramic substrate |
| 20 | side member |
| 31 | red-aimed phosphor |
| 32 | green-aimed phosphor |
| 33 | blue-aimed phosphor |
| 34, 35, 36 | ultraviolet emission cell |
| 37, 38, 39, 40 | electrode |
| 41, 42 | dielectric layer |
| 43 | protection layer |
| 44, 45 | glass substrate |

BEST MODE FOR CARRYING OUT THE INVENTION

The present invention will be described in detail based on Examples and drawings.

The phosphors of the present invention are compositions including at least an activation element M, a divalent alkaline earth element A, Al, Si, nitrogen, and oxygen. Examples of representative constituent elements include: as M, one kind or two or more kinds of element(s) selected from Mn, Ce, Nd, Sm, Eu, Tb, Dy, Ho, Er, Tm, and Yb; and as A, one kind or two or more kinds of element(s) selected from Mg, Ca, Sr, and Ba. These constituent elements allow for obtainment of phosphors exhibiting emission in an orange or red region.

Host crystals constituting the phosphors of the present invention are substitutional solid solutions, which are represented by $A_2Si_{5-x}Al_xO_xN_{8-x}$, (x is a value between 0.05 inclusive and 0.8 inclusive) where a part of Si is substituted by Al, and a part of N is substituted by O in an $A_2Si_5O_8$ crystal, and which accordingly have crystal structures similar to that of the $A_2Si_5O_8$ crystal. It has been never reported that Al and O are dissolved in a solid state in the form of composition formula $A_2Si_{5-x}Al_xO_xN_{8-x}$. Thus, the composition formula is a knowledge found by the present inventors for the first time, and represents crystals synthesized by the present invention for the first time.

There are obtained phosphors each for emitting orange or red light, by dissolving, in a solid state, a metallic element M (M is a one kind or two or more kinds of element(s) selected from Mn, Ce, Nd, Sm, Eu, Tb, Dy, Ho, Er, Tm, Yb) in an $A_2Si_{5-x}Al_xO_xN_{8-x}$ host crystal. The solid-state dissolution of Al and oxygen in the $A_2Si_5O8$ crystal increases chemical stability thereof, thereby improving durability of the phosphor. Substitution amounts "x" less than 0.05 lead to less improving effects of chemical stability, and substitution amounts "x" exceeding 0.8 lead to unstable crystal structures, thereby deteriorating luminances of the phosphors. As such, the range of "x" is preferably between 0.05 inclusive and 0.8 inclusive in value. Further, since values between 0.2 inclusive and 0.5 inclusive allow for obtainment of phosphors simultaneously having excellent chemical stability and higher luminances, compositions having values in this range are desirable.

The $A_2Si_{5-x}Al_xO_xN_{8-x}$ acting as the host materials of the phosphors each have the same crystal structure as the $A_2Si_5O_8$ (A is Mg, Ca, Sr, or Ba), and only the lattice constants are changed in compositions having small amounts of solid solutions, respectively. Thus, the inorganic compounds of the present invention can be identified by X-ray diffractometry.

Since solid-state dissolution of M is conducted by substitution for a position of the A element, preferable compositions are $A_{2-y}Si_5$-$Al_xO_xN_{8-x}$: $M_y$. Larger deviations from this composition lead to increase of a ratio of a second phase other than inorganic compounds including $A_2Si_{5-x}Al_xO_xN_{8-x}$, as host materials, thereby deteriorating luminances. The "y" value indicating a content of M relative to the whole of the inorganic compound is to be in a range between 0.001 inclusive and 0.5 inclusive, which allows for obtainment of phosphors of higher luminances. Values less than 0.0001 atomic% lead to smaller amounts of atoms to be involved in light emission to thereby deteriorate luminances, and values larger than 5 atomic% lead to deteriorated luminances due to concentration quenching.

Among the A elements, Ca and Sr are ones for achieving particularly higher luminances. Since phosphors adopting them are different in light emission color, selection may be preferably conducted depending on usage.

Adoption of Eu as the metallic element M allows for obtainment of an emission characteristic having a peak in a range of 570 to 650 nm, and is thus desirable for a red-aimed phosphor for lighting usage.

Combinations of A and M in the present invention for obtaining particularly higher luminances are $Ca_2Si_5N_8$: Eu where A is Ca and M is Eu, and $Sr_2Si_5N_8$: Eu where A is Sr and M is Eu.

It is desirable to mix Ca and Sr, in case of particular requirements of phosphors for intermediate color tones. Desirable examples are solid solution crystal compositions represented by $Sr_aCa_bSi_{5-x}Al_xO_xN_{8-x}$:$Eu_y$ (a+b=2-y), and where a/(a+b) value is between 0.2 inclusive and 1.8 inclusive, since such compositions have higher luminances and are large in color tone change.

In case of utilizing the phosphor of the present invention as a powder, averaged particle sizes between 0.1 $\mu$m inclusive and 20 $\mu$m inclusive are desirable, from standpoints of dispersibility into resin, flowability of the powder, and the like. Additionally, making the powder as single crystal particles in this range, further improves emission luminance.

To obtain a phosphor having a higher emission luminance, it is desirable to extremely decrease impurities included in the applicable inorganic compound. Particularly, since light emission is obstructed by inclusion of large amounts of Fe, Co, Ni impurity elements, it is desirable to control selecting and synthesizing processes for starting material powders such that the total amount of these impurity elements is limited to 500ppm or less.

In the present invention, although the $A_2Si_{5-x}Al_xO_xN_{8-x}$:$M_y$ compositions acting as constituent components of the oxynitrides are to be highly pure and to be included as much as possible, and are to be possibly and desirably constituted of a single phase from a standpoint of fluorescence emission, it is also possible to constitute the composition by a mixture with another crystal phase or amorphous phase within an extent where due properties are not deteriorated.

In this case, it is desirable that the content of $A_2Si_{5-x}Al_xO_xN_{8-x}$:$M_y$ composition is 10 mass% or more, so as to obtain higher luminance. More preferably, luminance is remarkably improved by 50 mass% or more.

For the range of the main component in the present invention, the content of the $A_2Si_{5-x}Al_xO_xN_{8-x}$:$M_y$ composition

is at least 10 mass% or more. The content of the $A_2Si_{5-x}Al_xO_xN_{8-x}:M_y$ composition can be obtained by multi-phase analysis based on a Rietveld method while conducting X-ray diffractometry. Expediently, it is possible to obtain the content of the $A_2Si_{5-x}Al_xO_xN_{8-x}:M_y$ composition from a ratio of maximum line thereof to those of other crystals by using an X-ray diffractometry result.

When the phosphor of the present invention is used for application where the same is excited by electron beam, it is possible to provide the phosphor with electroconductivity by mixing an inorganic substance having electroconductivity with the phosphor. Examples of inorganic substances having electroconductivity include oxides, oxynitrides, nitrides, and mixtures thereof each including one kind or two or more kinds of element(s) selected from zn, Ga, In, and Sn.

Although the phosphors of the present invention emit red light, it is possible to mix inorganic phosphors therewith which emit other color(s) such as yellow, green, blue, and the like as required, when the red color is required to be mixed with such other color(s).

The phosphors of the present invention are different in excitation spectra and fluorescence spectra depending on compositions, and appropriate selections and combinations of compositions enable for phosphors established to have various fluorescence spectra, respectively. Configurations thereof may be set for required spectra, depending on usages.

Among them, those compositions including Eu as the M element, and Ca or Sr, or both as the A element in $A_2Si_{5-x}Al_xO_xN_{8-x}:M_y$ exhibit emission having peaks at wavelengths in a range between 600 nm inclusive and 700 nm inclusive when excited by light at wavelengths in a range between 200 nm inclusive and 600 nm inclusive, thereby exhibiting excellent emission characteristics as red-aimed phosphors.

As compared with ordinary oxide phosphors or existing sialon phosphors, the phosphors of the present invention to be obtained in the above manner are characterized in that: the present phosphors have wider excitation ranges from electron beam, to X-rays, ultraviolet light, and visible light; that the phosphors exhibit orange or red light emission at 570 nm or longer; and that the phosphors of specific compositions exhibit red light from 600 nm to 700 nm; in a manner to exhibit red light emission in a color range where $0.45 \leq x \leq 0.7\,7$ in terms of (x, y) values on CIE chromaticity coordinates. Based on the above emission characteristics, the phosphors are desirable for a lighting instrument and an image displaying apparatus.

Additionally, the phosphors are excellent in heat resistance since the same are never deteriorated even when exposed to high temperatures, and the phosphors are also excellent in long-term stability in an oxidative atmosphere and a moisture environment.

Although the phosphors of the present invention are not defined in production method, it is possible to produce the phosphors having higher luminance by the following methods.

It is possible to obtain a higher luminance phosphor by firing, in an inert atmosphere containing nitrogen at a temperature range from 1,200°C inclusive and 2,200°C inclusive, a starting material mixture or metallic compound mixture which is capable of constituting a composition represented by M, A, Si, Al, O, and N when fired.

In case of synthesizing a phosphor containing Eu, Ca, Si, Al, N, and O, it is desirable to adopt, as starting materials, a powdery mixture of europium nitride or europium oxide, calcium nitride, silicon nitride, and aluminum nitride. These nitride starting materials usually contain oxygen as impurities serving as oxygen sources.

Further, in case of synthesizing compositions containing strontium, addition of strontium nitride in addition to the above formulation provides an inorganic compound where a part of calcium atom in the crystal is substituted by strontium, thereby allowing for obtainment of a phosphor exhibiting a higher luminance.

The mixed powder of metallic compounds is desirably fired in a state where the same is held at a filling ratio exhibiting a bulk density of 40% or less. The bulk density is a volumetric filling ratio of a powder of metallic compounds, and indicates a value to be obtained by dividing: a ratio of a mass to a volume of the powder filled in a constant container; by a theoretical density of the metallic compounds. Suitable as the container is a boron nitride sintered body, since it exhibits a lower reactivity with the metallic compounds.

The reason, why the starting material powder is to be fired in the state where its bulk density is held at 40% or less, is as follows. Namely, firing the powder in a state where free spaces are left around the powder, causes the crystals of reaction products to grow into the free spaces with less contact among the crystals, thereby enabling synthesis of a crystal having fewer surface defects.

Next, the thus obtained metallic compound mixture is fired at a temperature range between 1,200°C inclusive and 2,200°C inclusive in an inert atmosphere containing nitrogen, thereby synthesizing a phosphor. Since the firing temperature is high and the firing environment is an inert atmosphere containing nitrogen, the furnace to be used for firing is preferably an electric one in a metal resistance heating type or black lead resistance heating type which utilizes carbon as a material for the hot portion of the furnace. The firing procedure is preferably a sintering procedure such as an ordinary pressure sintering method or a gas pressure sintering method where no mechanical pressurization is applied from the exterior, so as to conduct firing while keeping the bulk density high.

When the powder aggregation obtained by firing is firmly solidified, the same is to be pulverized by a pulverizer such as a ball mill, jet mill, or the like to be commonly used in factories. The pulverization is to be conducted until the averaged particle size becomes 20 $\mu$m or less. Particularly desirably, the averaged particle size is between 0.1 $\mu$m inclusive and 5 $\mu$m inclusive. Averaged particle sizes exceeding 20 $\mu$m lead to a deteriorated flowability of the powder and deteriorated dispersibility thereof in the resin, and lead to non-uniform emission intensities site by site upon fabricating a light emitting apparatus by combination with a light emitting element. Averaged particle sizes of 0.1 $\mu$m or less lead to a large number of defects at the surface of the phosphor powder, thereby deteriorating emission intensities depending on compositions of the phosphors.

Such defects introduced into the surface of the phosphor powder such as upon pulverization are decreased to improve luminance, by heat treating the phosphor powder after firing, the phosphor powder after pulverization treatment, or the phosphor powder after granularity adjustment, at a temperature between 1,000°C inclusive and the firing temperature inclusive.

Washing the product after firing by a solvent comprising water or an acidic water solution, allows for decrease of contents of a glass phase, second phase, or impurity phase included in the product, thereby improving luminance. In this case, it is possible to select, as the acid, a single of or a mixture of sulfuric acid, hydrochloric acid, nitric acid, hydrofluoric acid, and organic acids, and there can be obtained a remarkable effect for eliminating impurities by adopting a mixture of v and sulfuric acid.

As described above, the phosphors of the present invention each exhibit higher luminances than the conventional sialon phosphors, and are each less in luminance deterioration of the phosphor when exposed to an excitation source, so that the phosphors of the present invention are suitably utilized for VFD, FED, PDP, CRT, white LED, and the like.

The lighting instrument of the present invention is constituted of at least a light-emitting source and the phosphor of the present invention. Examples of the lighting instruments include an LED lighting instrument, a fluorescent lamp, and the like. LED lighting instruments can be produced by utilizing the phosphors of the present invention, based on the known methods such as described in JP-A-5-152609, JP-A-7-99345, JP-2927279, and the like. In this case, desirable examples of light-emitting sources include ones for emitting light at wavelengths of 330 to 500 nm, and particularly, ultraviolet (or violet) LED light emitting elements for 330 to 420 nm, or blue LED light emitting elements for 420 to 500 nm.

Such light emitting elements include ones comprising nitride semiconductor such as GaN, InGaN, or the like, which can be made into light-emitting sources for emitting light at predetermined wavelengths by composition adjustment.

In addition to the way to solely adopt the phosphor of the present invention in a lighting instrument, it is possible to constitute a lighting instrument for emitting light in a desired color by combiningly using a phosphor having another emission characteristic. Examples thereof include a combination of: an ultraviolet LED light emitting element of 330 to 420 nm; a blue-aimed phosphor to be excited at the above-mentioned wavelength to thereby have an emission peak at a wavelength between 420 nm inclusive and 480 nm inclusive; a green-aimed phosphor to be similarly excited to thereby have an emission peak at a wavelength between 500 nm inclusive and 550 nm inclusive; and the phosphor of the present invention. Examples of such blue-aimed phosphors include $BaMgAl_{10}O_{17}$:Eu, and examples of such green-aimed phosphors include $BaMgA_{10}O_{17}$:Eu, Mn, and $\beta$-sialon:Eu obtained by dissolving Eu, in a solid state, in $\beta$-sialon. In this configuration, ultraviolet rays emitted by the LED are irradiated to the phosphors which then emit light in three colors of red, blue, and green, thereby establishing a lighting instrument for emitting white light mixedly including these light.

Another way includes a combination of: a blue LED light emitting element of 420 to 500 nm; a yellow-aimed phosphor to be excited at the above-mentioned wavelength to thereby have an emission peak at a wavelength between 550 nm inclusive and 600 nm inclusive; and the phosphor of the present invention. Examples of such yellow-aimed phosphors include $(Y, Gd)_2(Al, Ga)_5O_{12}$:Ce described in JP-2927279, $\alpha$-sialon:Eu described in JP-A-2002-363554, and the like. Among them, Ca-$\alpha$-sialon including Eu dissolved therein in a solid state is preferable by virtue of a higher emission luminance. In this configuration, blue light emitted by the LED is irradiated to the phosphors which then emit light in two colors of red and yellow, which light is mixed with the blue light by the LED itself, thereby establishing a lighting instrument for emitting light in white or reddish incandescent color.

Still another way includes a combination of: a blue LED light emitting element of 420 to 500 nm; a green-aimed phosphor to be excited at the above-mentioned wavelength to thereby have an emission peak at a wavelength between 500 nm inclusive and 570 nm inclusive; and the phosphor of the present invention. Examples of such green-aimed phosphors include $Y_2Al_5O_{12}$:Ce, $\beta$-sialon:Eu which is obtained by dissolving Eu, in a solid state, in $\beta$-sialon, and the like. In this configuration, blue light emitted by the LED is irradiated to the phosphors which then emit light in two colors of red and green, which light is mixed with the blue light by the LED itself, thereby establishing a lighting instrument for emitting white light.

The image displaying apparatus of the present invention is constituted of at least an excitation source and the phosphor of the present invention, and examples thereof include a vacuum fluorescent display (VFD), field emission display (FED), plasma display panel (PDP), cathode ray tube (CRT), and the like. It has been confirmed that the phosphors of the present invention can each emit light by excitation of vacuum ultraviolet light from 100 to 190 nm, ultraviolet light from 190 to 380 nm, electron beam, and the like, and combining such an excitation source with the phosphor of the present invention enables establishment of such an image displaying apparatus as described above.

Examples:

Although the present invention will be detailedly described based on the following Examples, these Examples are merely disclosed to aid in readily understanding the present invention, without limiting the present invention thereto.

Example 1:

Used for preparation of a starting material powder were: a silicon nitride powder having an averaged particle size of 0.5 $\mu$m, an oxygen content of 0.93wt%, and an $\alpha$-type content of 92%; an aluminum nitride powder having a specific surface area of 3.3 m$^2$/g, and an oxygen content of 0.79%; an aluminum oxide powder having a specific surface area of 13.6 m$^2$/g; a strontium nitride powder; and a europium nitride powder synthesized by nitriding metal europium in ammonia.

To obtain a compound represented by a composition formula $Eu_{0.001}Sr_{0.1323}Al_{0.0333}Si_{0.3}O_{0.0333}N_{0.5}$ (Table 1 shows parameters of designed compositions, and Table 2 shows mixture compositions of starting material powders), there were weighed 49wt%, 1.592wt%, 3.96wt%, 44.84wt%, and 0.58wt% of a silicon nitride powder, an aluminum nitride powder, an aluminum oxide powder, a strontium nitride powder, and a europium nitride powder; and the powders were then mutually mixed for 30 minutes by an agate pestle and an agate mortar.

The obtained mixture was naturally dropped into a crucible made of boron nitride through a sieve of 500 $\mu$m, thereby filling the powder into the crucible. The powder had a bulk density of about 24%. Note that operations of all the weighing, mixing, and shaping procedures of the powders were conducted within a glove box capable of maintaining a nitrogen atmosphere including a moisture of 1ppm or less and oxygen of 1ppm or less.

The mixed powder was introduced in the crucible made of boron nitride which was then set in an electric furnace of a black lead resistance heating type. There was conducted a firing operation by firstly bringing the firing environment to vacuum by a diffusion pump, heating from a room temperature up to 800°C at a rate of 500°C/hour, introducing nitrogen at a purity of 99.999vol% at 800°C to achieve a pressure of 0.5 MPa, elevating the temperature to 1,70C°C at a rate of 500°C/hour, and holding for 2 hours at 1,700°C.

After firing, the obtained fired body was roughly pulverized, and then manually pulverized by a crucible and a mortar both made of silicon nitride sintered body, followed by passage through a sieve of 30 $\mu$m mesh. Measurement of particle size distribution showed an averaged particle size of 8 $\mu$m

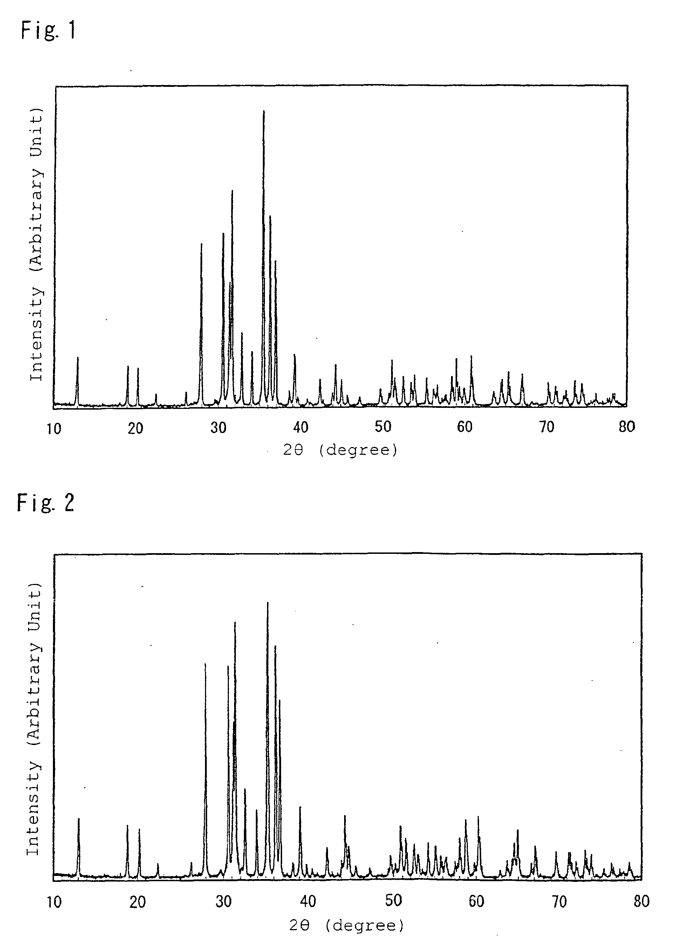

Next, the synthesized compound was pulverized by an agate mortar, and there was conducted a powder X-ray diffraction measurement by K$\alpha$ line of Cu. The resultingly obtained chart is shown in FIG. 1, while FIG. 2 shows a chart of $Sr_2Si_5N_8$ (synthesized in Comparative Example 2) for comparison. From the X-ray diffractometry, it has been confirmed that the synthesized inorganic compound has the same crystal structure as $Sr_2Si_5N_8$ such that only a lattice constant was changed, and thus the synthesized inorganic compound is a solid solution of $Sr_2Si_5N_8$. Further, there have not been detected any phases other than $Sr_2Si_{5-x}Al_xO_xN_{8-x}$.

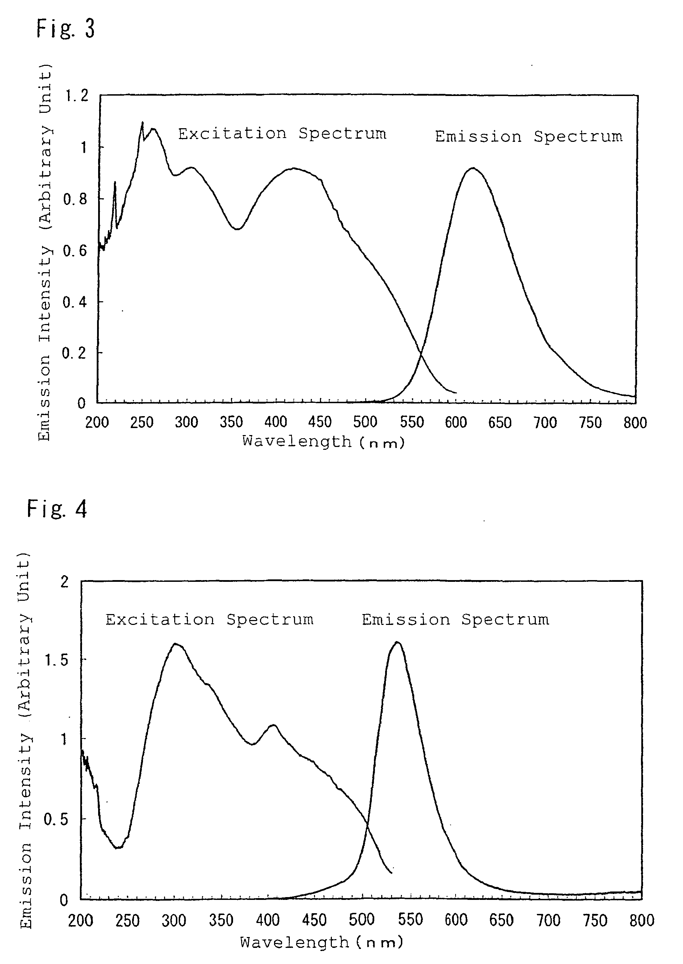

This powder was irradiated by a lamp emitting light at a wavelength of 365 nm, thereby confirming that the powder emitted red light. The powder was measured by a spectrophotofluorometer to provide an emission spectrum and an excitation spectrum (FIG. 3), thereby resultingly showed that the powder was a phosphor having a peak at 418 nm in the excitation spectrum, and a peak at red light of 617 nm in the emission spectrum based on the excitation of 418 nm. The emission intensity at the peak was 0.9475 count. Note that the count value has an arbitrary unit, since it varies depending on a measurement device, a measurement condition, and the like.

In the present invention, the count value is indicated by standardization such that the emission intensity at 568 nm of a commercially available YAG:Ce phosphor (P46Y3: produced by KASEI OPTONIX, LTD.) becomes 1, by excitation of 450 nm.

Further, the CIE chromaticity obtained from the emission spectrum based on the excitation of 418 nm was red where x=0.5776 and y=0.3616.

This phosphor exhibited substantially no deterioration of luminance, even after exposure for 100 hours under a condition of a humidity of 80% and a temperature of 80°C.

Comparative Example 2:

To obtain a compound represented by a composition formula $Eu_{0.001}Sr_{0.1323}Si_{0.3333}N_{0.5333}$ and including no A1 and oxygen (Table 1 shows parameters of designed compositions, and Table 2 shows mixture compositions of starting material powders) by using the same starting material powder as Example 1, there were weighed 54.5wt%, 44.89wt%, and 0.58wt%, of a silicon nitride powder, a strontium nitride powder, and a europium nitride powder; and the powders were then mutually mixed for 30 minutes by an agate pestle and an agate mortar. The phosphor was synthesized thereafter, by the same procedures as those in Example 1.

Next, the synthesized compound was pulverized by an agate mortar, and there was conducted a powder X-ray diffraction measurement by K$\alpha$ line of Cu, thereby resultingly detecting a single phase of $Sr_2Si_5N_8$ as shown in FIG. 2.

This powder was irradiated by a lamp emitting light at a wavelength of 365 nm, thereby confirming that the powder emitted red light. The powder was measured by a spectrophotofluorometer to provide an emission spectrum and an excitation spectrum, thereby resultingly showed that the powder was a phosphor having a peak at 427 nm in the excitation spectrum, and a peak at red light of 612 nm in the emission spectrum based on the excitation of 427 nm. The emission intensity at the peak was 1.0932 count. Further, the CIE chromaticity obtained from the emission spectrum based on the excitation of 427 nm was red where x=0.5413 and y=0.3275.

This phosphor exhibited a 70% deterioration of luminance, after exposure for 100 hours under a condition of a humidity of 80% and a temperature of 80°C.

This phosphor has a higher emission intensity than that of Example 1, but is inferior thereto in chemical stability.

Comparative Example 3:

To obtain a compound represented by a composition formula $Eu_{0.001}Sr_{0.1323}Al_{0.1333}Si_{0.2}O_{0.1333}N_{0.4}$ (Table 1 shows parameters of designed compositions, and Table 2 shows mixture compositions of starting material powders) by using the same starting material powder as Example 1, there were weighed 32.6wt%, 6.347wt%, 15.79wt%, 44.7wt%, and 0.58wt%, of a silicon nitride powder, an aluminum nitride powder, an aluminum oxide powder, a strontium nitride powder, and a europium nitride powder; and the powders were then mutually mixed for 30 minutes by an agate pestle and an agate mortar. The phosphor was synthesized thereafter, by the same procedures as those in Example 1.

Next, the synthesized compound was pulverized by an agate mortar, and there was conducted a powder X-ray diffraction measurement by K$\alpha$ line of Cu, thereby resultingly detecting an unknown phase in addition to an $A_2Si_{5-x}Al_xO_xN_{8-x}$ crystal.

This powder was irradiated by a lamp emitting light at a wavelength of 365 nm, thereby confirming that the powder emitted red light. The powder was measured by a spectrophotofluorometer to provide an emission spectrum and an excitation spectrum, thereby resultingly showed that the powder was a phosphor having a peak at 412 nm in the excitation spectrum, and a peak at red light of 624 nm in the emission spectrum based on the excitation of 412 nm. The emission intensity at the peak was 0.6635 count. Further, the CIE chromaticity obtained from the emission spectrum based on the excitation of 412 nm was red where x=0.5969 and y=0 3967.

This phosphor exhibited no deterioration of luminance, even after exposure for 100 hours under a condition of a humidity of 80% and a temperature of 80°C.

This phosphor is excellent in chemical stability, but is considerably deteriorated in emission intensity.

Examples 4 through 10:

Used as starting material powders were: a silicon nitride ponder having an averaged particle size of 0.5 $\mu$m, an oxygen content of 0.93wt%, and an $\alpha$-type content of 92%; an aluminum nitride powder having a specific surface area of 3.3 $m^2$/g, and an oxygen content of 0.79%; an aluminum oxide powder having a specific surface area of 13.6 $m^2$/g; a magnesium nitride powder; a strontium nitride powder; a calcium nitride powder; a barium nitride powder; and a europium nitride powder synthesized by nitriding metal europium in ammonia.

To obtain compositions comprising designed composition parameters listed in Table 1, powders were weighed according to mixture compositions listed in Table 2, thereby synthesizing inorganic compounds by the same procedures as those in Example 1.

Next, the synthesized compounds were each pulverized by an agate mortar. The powders were measured by a spectrophotofluorometer, thereby obtaining emission spectra and excitation spectra having excitation and emission properties listed in Table 3, respectively.

Among them, the inorganic compound ($CaSrSi_{4.5}Al_{0.5}O_{0.5}N_{7.5}$:Eu) as shown in Example 5 is high in emission intensity and excellent in chemical stability, and additionally has an emission wavelength of 637 nm which is desirable as a phosphor for a lighting apparatus, image displaying apparatus, and the like, thereby providing a practically excellent composition. This inorganic compound was measured by X-ray diffractometry, thereby confirming that it is a solid solution having the same crystal structure as $Sr_2Si_5N_8$.

The results of Examples and Comparative Examples are collectively listed in Table 1 through Table 3 below.

Table 1 shows parameters of designed compositions of Examples/Comparative Examples 1 through 10, respectively.

Table 2 shows mixture compositions of starting material powders of Examples/Comparative Examples 1 through 10, respectively.

Table 3 shows peak wavelengths of excitation spectra, and peak wavelengths and peak intensities of emission spectra of Examples/Comparative Examples 1 through 10, respectively.

Table 1:

| | Parameter Composition Formula | | | | | | | | | | |
|---|---|---|---|---|---|---|---|---|---|---|---|
| | x | y | Eu | Mg | Ca | Sr | Ba | Si | Al | O | N |
| Ex. 1. | 0.5 | 0.001 | 0.001 | 0 | 0 | 0.1323 | 0 | 0.3 | 0.0333 | 0.0333 | 0.5 |
| Com. Ex. 2 | 0 | 0.001 | 0.001 | 0 | 0 | 0.1323 | 0 | 0.3333 | 0 | 0 | 05333 |
| Com. Ex. 3 | 2 | 0.001 | 0.001 | 0 | 0 | 0.1323 | 0 | 0.2 | 0.1333 | 0.1333 | 0.4 |
| Ex. 4 | 0.5 | 0.001 | 0.001 | 0 | 0.1323 | 0 | 0 | 0.3 | 0.0333 | 0.0333 | 0.5 |
| Ex. 5 | 0.5 | 0.001 | 0.001 | 0 | 0.0662 | 0.0662 | 0 | 0.3 | 0.0333 | 0.0333 | 0.5 |
| Ex. 6 | 0.5 | 0.001 | 0.001 | 0 | 0 | 0 | 0.1331 | 0.2994 | 0.0333 | 0.0333 | 0.5 |
| Ex. 7 | 0.1 | 0.001 | 0.001 | 0 | 0 | 0.1331 | 0 | 0.326 | 0.0067 | 0.0067 | 0.5266 |
| Ex. 8 | 0.2 | 0.001 | 0.001 | 0 | 0 | 0.1331 | 0 | 0.3194 | 0.0133 | 0.0133 | 0.52 |
| Ex. 9 | 0.3 | 0.001 | 0.001 | 0 | 0 | 0.1331 | 0 | 0.3127 | 0.02 | 0.02 | 0.5133 |
| Ex. 10 | 0.7 | 0.001 | 0.001 | 0 | 0 | 0.1331 | 0 | 0.2861 | 0.6466 | 0.0466 | 0.4867 |

Table 2:

| | Mixture Composition (mass%) | | | | | | | |
|---|---|---|---|---|---|---|---|---|
| | $Si_3N_4$ | AlN | $Al_2O_3$ | $Mg_3N_2$ | $Ca_3N_2$ | $Sr_3N_2$ | $Ba_3N_2$ | EuN |
| Ex. 1 | 49 | 1.592 | 3.96 | 0 | 0 | 44.84 | 0 | 0.58 |
| Com. Ex. 2 | 54.5 | 0 | 0 | 0 | 0 | 44.89 | 0 | 0.58 |
| Com. Ex. 3 | 32.6 | 6.347 | 15.79 | 0 | 0 | 44.7 | 0 | 0.58 |
| Ex. 4 | 62.8 | 2.04 | 6.08 | 0 | 29.3 | 0 | 0 | 0.75 |
| Ex. 5 | 55.1 | 1.788 | 4.45 | 0 | 12.84 | 25.19 | 0 | 0.65 |
| Ex. 6 | 39.7 | 1.289 | 3.21 | 0 | 0 | 0 | 55.34 | 0.47 |
| Ex. 7 | 53.2 | 0.318 | 0.79 | 0 | 0 | 45.07 | 0 | 0.58 |
| Ex. 8 | 52.1 | 0.635 | 1.58 | 0 | 0 | 45.06 | 0 | 0.58 |
| Ex. 9 | 51.1 | 0.952 | 2.37 | 0 | 0 | 45.05 | 0 | 0.58 |
| Ex. 10 | 46.67 | 2.22 | 5.52 | 0 | 0 | 45.01 | 0 | 0.58 |

Table 3:

| | Excitation Spectrum | | Emission Spectrum | |
|---|---|---|---|---|
| | Wavelength | Intensity (arbitrary intensity) | Maximum Emission Wavelength(nm) | Intensity (arbitrary intensity) |
| Ex. 1 | 418 | 0.9205 | 617 | 0.9475 |
| Com. Ex. 2 | 427 | 1.1237 | 612 | 1.0932 |
| Com. Ex. 3 | 412 | 0.6794 | 624 | 0.6635 |
| Ex. 4 | 373 | 0.7179 | 597 | 0.7013 |
| Ex. 5 | 419 | 0.9853 | 637 | 0.9596 |

(continued)

| | Excitation Spectrum | | Emission Spectrum | |
|---|---|---|---|---|
| | Wavelength | Intensity (arbitrary intensity) | Maximum Emission Wavelength(nm) | Intensity (arbitrary intensity) |
| Ex. 6 | 290 | 0.9046 | 585 | 0.906 |
| Ex. 7 | 263 | 1.4604 | 618 | 1.507 |
| Ex. 8 | 248 | 1.1777 | 620 | 1.1117 |
| Ex. 9 | 248 | 1.0108 | 618 | 0.991 |
| Ex. 10 | 248 | 1.0255 | 624 | 1.0128 |

There will be now explained lighting instruments each adopting the phosphor comprising the nitride of the present invention.

Example 11:

As a green-aimed phosphor to be used for a lighting instrument, there was synthesized a phosphor ($\beta$-sialon: Eu) having the following composition, by the procedure below.

Firstly, to obtain a compound represented by a composition formula $Eu_{0.00296}Si_{0.41395}Al_{0.01334}O_{0.00444}N_{0.56528}$, there were mixed a silicon nitride powder, an aluminum nitride powder, and a europium oxide powder at a ratio of 94.77wt%, 2.68wt%, and 2.556wt%, respectively, followed by loading into a crucible made of boron nitride and by firing for 8 hours at 1,900°C in nitrogen gas at 1 MPa.

The thus obtained powder was an inorganic compound comprising $\beta$-sialon containing Eu dissolved therein in a solid state, and was a green-aimed phosphor as seen from an excitation spectrum and an emission spectrum of FIG. 4.

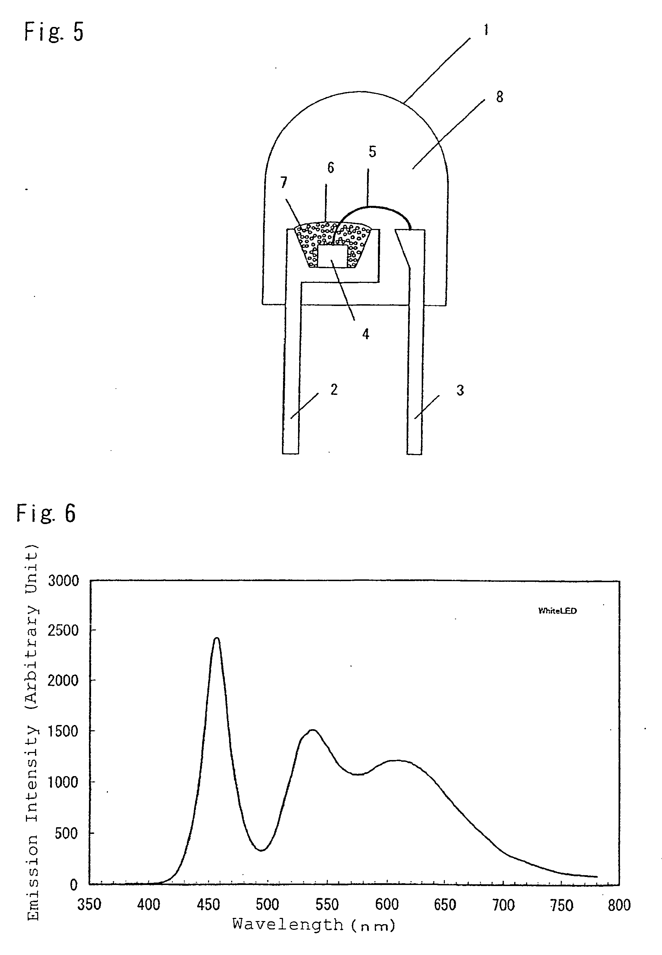

There was fabricated a so-called bullet-type white light emitting diode lamp (1) shown in FIG. 5. It included two lead wires (2, 3), one (2) of which had a depression having a blue light emitting diode element (4) placed therein. The blue light emitting diode element (4) had a lower electrode electrically connected to a bottom surface of the depression by an electroconductive paste, and an upper electrode electrically connected to the other lead wire (3) via thin gold line (5) .

There was used a phosphor obtained by mixing a first phosphor and a second phosphor. The first phosphor was the $\beta$-sialon:Eu synthesized in this Example, and the second phosphor was one synthesized in Example 1. Mounted near the light emitting diode element (4) was the phosphor (7) obtained by mixing the first phosphor and the second phosphor and which was dispersed in a resin. The phosphors were dispersed in a first resin (6) which was transparent and which covered the whole of the blue light emitting diode element (4). Encapsulated in a second transparent resin (8) were the tip end of the lead wire including the depression, the blue light emitting diode element, and the first resin including the phosphors dispersed therein. The second transparent resin (8) was in a substantially column shape as a whole, and had a tip end portion of a curved surface in a lens shape, which is typically called a bullet type.

In this Example, the mixing ratio between the first phosphor powder and second phosphor powder was set to be 5:1, this mixed powder was blended into an epoxy resin at a concentration of 35wt%, and the resultant resin was dropped at an appropriate amount by a dispenser, thereby forming the first resin (6) including the mixedphosphor(7) dispersed therein. The obtained chromaticity was white where x=0.33 and y=0.33. FIG. 6 shows an emission spectrum of this white light emitting diode.

There will be next explained a producing procedure of the bullet type white light emitting diode of this first configuration. Firstly, the blue light emitting diode element (4) is die-bonded by an electroconductive paste onto the element placement depression of one (2) of the paired lead wires, to thereby electrically connect the lead wire to the lower electrode of the blue light emitting diode element and to fix the blue light emitting diode element (4). Next, the upper electrode of the blue light emitting diode element (4) is die bonded to the other of lead wires, thereby electrically connecting them to each other.

Previously mixed with each other at a mixing ratio of 5:1 are the first green-aimed phosphor powder and the second red-aimed phosphor powder, and this mixed phosphor powder is mixed into an epoxy resin at a concentration of 35wt%. Next, the resultant resin is coated in an appropriate amount onto the depression to cover the blue light emitting diode element, and then cured to form the first resin (6).

Finally, the tip end of the lead wire including the depression, the blue light emitting diode element, and the first resin including the phosphors dispersed therein, are wholly encapsulated in the second resin by a casting method.

Although the same epoxy resin was used for the first resin and second resin in this Example, it is possible to adopt another resin such as a silicone resin, or a transparent material such as glass. It is desirable to select a material which is less in degradation due to ultraviolet light.

Example 12:

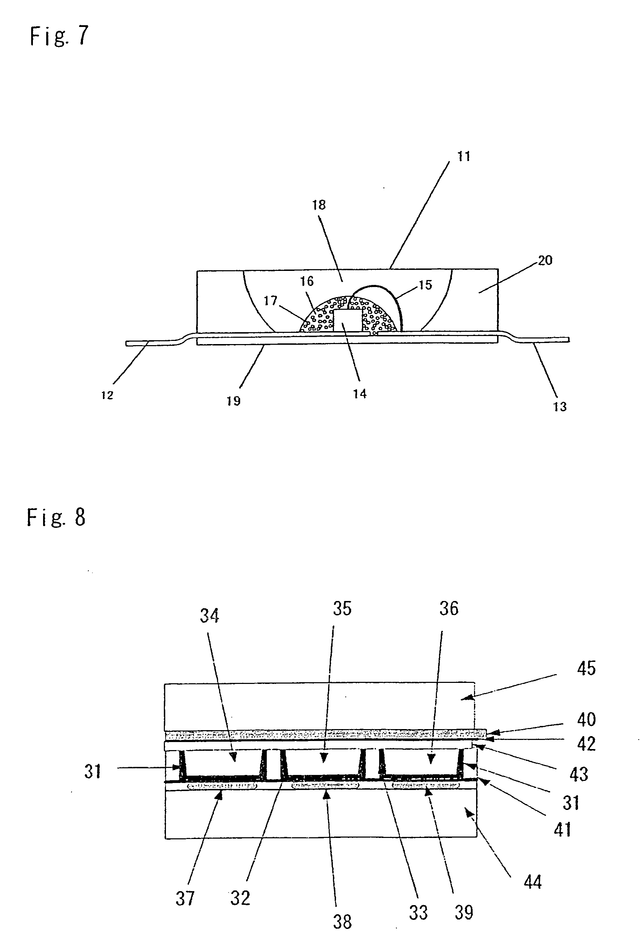

There was fabricated a chip-type white light emitting diode lamp (11) to be mounted on a substrate. Its configuration is shown in FIG. 7.

It included a white alumina ceramic substrate (19) having a higher reflectivity to visible light, and two lead wires (12, 13) fixed thereto, and the lead wires each included one end located at substantially the center position of the substrate, and the other end drawn out to the exterior to form an electrode to be soldered to an electric substrate upon mounting thereto. Placed onto and fixed to the one end of one (12) of the lead wires, was a blue light emitting diode element (14) so as to be located at the central portion of the substrate. The blue light emitting diode element (14) had a lower electrode electrically connected to the lead wire thereunder by an electroconductive paste, and an upper electrode electrically connected to the other lead wire (13) by a thin gold line (15).

Mounted near the light emitting diode element was a resin including a phosphor (17) which was dispersed therein and which was obtained by mixing a first resin and a second phosphor with each other. The first resin (16) including the phosphor dispersed therein was transparent and covered the whole of the blue light emitting diode element (14).

Further, fixed on the ceramic substrate was a wall surface member (20) in a shape having a hole at a central portion. As shown in FIG. 7, the wall surface member (20) had its central portion acting as the hole for accommodating therein the blue light emitting diode element (14) and the first resin (16) including the phosphor (17) dispersed therein, and had a portion which was faced to the center and which was formed into an inclined surface. This inclined surface was a reflective surface for forwardly directing light-beams, and had a curved shape to be determined in consideration of the reflected directions of light-beams.

Furthermore, at least the surface which constituted the reflective surface, was formed into a surface which was white in color or had metallic luster and which had a higher reflectivity to visible light. In this embodiment, the wall surface member was constituted of a white silicone resin (20). While the hole of the wall surface member at its central portion constitutes a depression as a final shape of the chip-type light emitting diode lamp, the depression is filled with a second transparent resin (18) in a manner to encapsulate all the blue light emitting diode element (14) and the first resin (16) including the phosphor (17) dispersed therein.

Adopted as the first resin (16) and second resin (18) in this Example was the same epoxy resin. The mixing ratio between the first phosphor and second phosphor, the achieved chromaticity, and the like were substantially the same as those of the first configuration.

The producing procedure was substantially the same as that of the first configuration, except for a step for fixing the lead wires (12, 13) and the wall surface member (20) to the alumina ceramic substrate (19).

Example 13:

There will be described a lighting apparatus having a configuration different from the above. This is provided based on the lighting apparatus of FIG. 5, in a structure including: a blue LED of 450 nm as a light emitting element; and a Phosphor dispersion resin layer covered on the blue LED, the resin layer being provided by dispersing, in a layer of resin, the phosphor of Example 1 of the present invention and a yellow-aimed phosphor of Ca-$\alpha$-sialon:Eu having a composition of

$Ca_{0.75}EU_{0.25}Si_{8.625}Al_{3.375}O_{1.125}N_{14.875}$.

Flowing an electric current through electroconductive terminals of the LED caused it to emit light at 450 nm, which excited the yellow-aimed phosphor and red-aimed phosphor to cause them to emit yellow light and red light, respectively, thereby confirming that the structure functioned as a lighting instrument for emitting incandescent color light mixedly including the LED light, yellow light, and red light.

Example 14:

There will be described a lighting apparatus having another configuration different from the above. This is provided based on the lighting apparatus of FIG. 5, in a structure including: an ultraviolet LED of 380 nm as a light emitting element; and a Phosphor dispersion resin layer covered on the ultraviolet LED, the resin layer being provided by dispersing, in a layer of resin, the phosphor of Example 1 of the present invention, a blue-aimed phosphor $(BaMgAl_{10}O_{17}:Eu)$, and a green-aimed phosphor $(BaMgAl_{10}O_{17}:Eu, Mn)$.

Flowing an electric current through electroconductive terminals of the LED caused it to emit light at 380 nm, which excited the red-aimed phosphor, green-aimed phosphor, and blue-aimed phosphor to cause them to emit red light, green light, and blue light, respectively. It was confirmed that the structure functioned as a lighting instrument for emitting white light mixedly including these light.

There will now be explained an exemplary design of an image displaying apparatus adopting the phosphor of the present invention.

Example 15:

FIG. 8 is a principle schematic view of a plasma display panel as an image displaying apparatus. The apparatus includes cells 34, 35, and 36 having inner surfaces coated with the red-aimed phosphor of Example 1 of the present invention, a green-aimed phosphor ($Zn_2SiO_4$:Mn) and a blue-aimed phosphor ($BaMgAl_{10}O_{17}$:Eu), respectively. it has been clarified that flow of electric current through electrodes 37, 38, 39, and 40 generates vacuum ultraviolet light by Xe discharge within the cells, to thereby excite the phosphors in a manner to emit visible light of red, green, and blue, respectively, so that these light are observed from the exterior through a protection layer 43, a dielectric layer 42, and a glass substrate 45, and thus the panel functions as an image displaying apparatus.

INDUSTRIAL APPLICABILITY

The nitride phosphors of the present invention exhibit emission at longer wavelengths than those by conventional sialon phosphors and oxynitride phosphors, are excellent as red-aimed phosphors, and are less in luminance deterioration even upon exposure to excitation sources, thereby serving as nitride phosphors preferably usable for VFD, FED, PDP, CRT, white LED, and the like. Thus, the nitride phosphors of the present invention can be expected to be utilized to a great extent in material design of various display devices, thereby contributing to development of the industry.

**Claims**

1. A phosphor, **characterized in that** the phosphor includes, as a main component, an inorganic compound comprising:

   a crystal represented by $A_2Si_{5-x}Al_xO_xN_{8-x}$ (A is a mixture of one kind or two or more kinds of element(s) selected from Mg, Ca, Sr, and Ba; and x is a value between 0.05 inclusive and 0.8 inclusive); and
   a metallic element M (M is one kind or two or more kinds of element(s) selected from Mn, Ce, Nd, Sm, Eu, Tb, Dy, Ho, Er, Tm, and Yb) dissolved, in a solid state, in the crystal.

2. The phosphor of claim 1, **characterized in that** x is a value between 0.05 inclusive and 0.5 inclusive.

3. The phosphor of claim or 2, **characterized in that** the inorganic compound comprises a solid solution crystal represented by $A_{2-y}Si_{5-x}Al_xO_xN_{8-x}$:$M_y$, and y is a value in a range of $0.001 \leq y \leq 0.5$.

4. The phosphor of claim 1, **characterized in that** the inorganic compound includes at least Eu as the metallic element M.

5. The phosphor of any one of claims 1 through 4, **characterized in that** the metallic element M is Eu and the metallic element A is Sr or Ca.

6. The phosphor of any one of claims 1 through 4, **characterized in that** the inorganic compound comprises a solid solution crystal represented by $Sr_aCa_bSi_{5-x}Al_xO_xN_{8-x}$:$Eu_y$, and values of "a" and "b" are within ranges, respectively, defined by:

   ɔhor powde

   and

   ɔhor powder after g

7. The phosphor of any one of claims 1 through 6, **characterized in that** the inorganic compound is a powder having an averaged particle size between 0.1 $\mu$m inclusive and 20 $\mu$m inclusive.

8. The phosphor of claim 1 **characterized in that** the phosphor further includes an additional crystal phase or amorphous phase in addition to the inorganic compound; and
that the inorganic compound is included at a content of 10 mass% or more.

9. The phosphor of claim 8, **characterized in that** the content of inorganic compound is 50 mass% or more.

10. The phosphor of claim 8 or 9, **characterized in that** the additional crystal phase or amorphous phase is an inorganic substance having electroconductivity.

11. The phosphor of claim 10, **characterized in that** the inorganic substance having electroconductivity is oxide, oxynitride, nitride, or a mixture thereof including one kind or two or more kinds of element(s) selected from Zn, Ga, In, and Sn.

12. The phosphor of any one of claims 1 through 11, **characterized in that** the phosphor emits orange or red fluorescence at a wavelength between 570 nm inclusive and 700 nm inclusive, by irradiation of an excitation source comprising ultraviolet light or visible light between 100 nm inclusive and 550 nm inclusive, or electron beam

13. The phosphor of claim 12, **characterized in that** the phosphor emits fluorescence having (x, y) values on CIE chromaticity coordinates satisfying a condition of $0.4{\leq}x{\leq}0.7$, upon irradiation by the excitation source.

14. A production method of the phosphor of any one of claims 1 through 13, **characterized in that** the method comprises the step of:

firing a starting material mixture in a nitrogen atmosphere at a pressure between 0.1 MPa inclusive and 100 MPa inclusive at a temperature range between 1,200°C inclusive and 2,200°C inclusive,
wherein the starting material mixture is a mixture of metallic compounds, and is capable of constituting a composition comprising M, A, Si, Al, O, and N (M is one kind or two or more kinds of element(s) selected from Mn, Ce, Nd, Sm, Eu, Tb, Dy, Ho, Er, Tm, and Yb; and A is one kind or two or more kinds of element(s) selected from Mg, Ca, Sr, and Ba).

15. A lighting instrument constituted of a light-emitting source and a phosphor according to any one of claims 1 through 13.

16. The lighting instrument of claim 15, **characterized in that** the light-emitting source is an LED for emitting light at a wavelength of 330 to 500 nm.

17. The lighting instrument of claim 15, **characterized in that** the light-emitting source is an LED for emitting light at a wavelength between 330 and 420 nm; and
that the phosphor further includes:

a blue-aimed phosphor having an emission peak at a wavelength between 420 nm inclusive and 500 nm inclusive by the light; and a green-aimed phosphor having an emission peak at a wavelength between 500 nm inclusive and 570 nm inclusive by the light.

18. The lighting instrument of claim 15, **characterized in that** the light-emitting source is an LED for emitting light at a wavelength between 420 and 500 nm; and
that the phosphor further includes a green-aimed phosphor having an emission peak at a wavelength between 500 nm inclusive and 570 nm inclusive by the light.

19. The lighting instrument of claim 15, **characterized in that** the light-emitting source is an LED for emitting light at a wavelength between 420 and 500 nm; and
that the phosphor further includes a yellow-aimed phosphor having an emission peak at a wavelength between 550 nm inclusive and 600 nm inclusive by the light.

20. An image displaying apparatus constituted of an excitation source and a phosphor according to any one of claims 1 through 13.

**Patentansprüche**

1. Leuchtstoff, **dadurch gekennzeichnet, dass** der Leuchtstoff als Hauptbestandteil eine anorganische Verbindung enthält, die aufweist:

   einen Kristall, dargestellt durch $A_2Si_{5-x}Al_xO_xN_{8-x}$ (A ist ein Gemisch aus einer Art oder zwei oder mehreren Arten von Elementen, ausgewählt unter Mg, Ca, Sr und Ba; und x ist ein Wert zwischen und einschließlich 0,05 und 0,8); und
   ein metallisches Element M (M ist eine Art oder mehrere Arten von Elementen, ausgewählt unter Mn, Ce, Nd, Sm, Eu, Tb, Dy, Ho, Er, Tm und Yb), das in einem festen Zustand in dem Kristall gelöst ist.

2. Leuchtstoff nach Anspruch 1, **dadurch gekennzeichnet, dass** x ein Wert zwischen und einschließlich 0,05 und 0,5 ist.

3. Leuchtstoff nach Anspruch 1 oder 2, **dadurch gekennzeichnet, dass** die anorganische Verbindung einen Mischkristall aufweist, der durch $A_2{-}ySi_{5-x}Al_xO_xN_{8-x}{:}M_y$ dargestellt wird, und y ein Wert in einem Bereich von $0{,}001 \leq y \leq 0{,}5$ ist.

4. Leuchtstoff nach Anspruch 1, **dadurch gekennzeichnet, dass** die anorganische Verbindung zumindest Eu als das metallische Element M enthält.

5. Leuchtstoff nach einem der Ansprüche 1 bis 4, **dadurch gekennzeichnet, dass** das metallische Element M Eu ist und das metallische Element A Sr oder Ca ist.

6. Leuchtstoff nach einem der Ansprüche 1 bis 4, **dadurch gekennzeichnet, dass** die anorganische Verbindung einen Mischkristall aufweist, der durch $Sr_aCa_bSi_{5-x}Al_xO_xN_{8-x}{:}Eu_y$ dargestellt wird, und die Werte von "a" bzw. "b" in Bereichen liegen, die durch

   ›ektrum aufⱽ

   und

   ⱡänge zwischen und ei⁚

   definiert sind.

7. Leuchtstoff nach einem der Ansprüche 1 bis 6, **dadurch gekennzeichnet, dass** die anorganische Verbindung ein Pulver mit einer mittleren Teilchengröße zwischen und einschließlich 0,1 $\mu$m und 20 $\mu$m ist.

8. Leuchtstoff nach Anspruch 1, **dadurch gekennzeichnet, dass** der Leuchtstoff außer der anorganischen Verbindung ferner eine zusätzliche Kristallphase oder amorphe Phase enthält; und
   dass die anorganische Verbindung mit einem Gehalt von 10 Masse-% oder mehr enthalten ist.

9. Leuchtstoff nach Anspruch 8, **dadurch gekennzeichnet, dass** der Gehalt der anorganischen Verbindung 50 Masse-% oder mehr beträgt.

10. Leuchtstoff nach Anspruch 8 oder 9, **dadurch gekennzeichnet, dass** die zusätzliche Kristallphase oder amorphe Phase eine anorganische Substanz mit elektrischer Leitfähigkeit ist.

11. Leuchtstoff nach Anspruch 10, **dadurch gekennzeichnet, dass** die anorganische Substanz mit elektrischer Leitfähigkeit ein Oxid, Oxynitrid, Nitrid oder ein Gemisch davon ist, das eine Art oder zwei oder mehr Arten von Elementen enthält, die unter Zn, Ga, In und Sn ausgewählt sind.

12. Leuchtstoff nach einem der Ansprüche 1 bis 11, **dadurch gekennzeichnet, dass** der Leuchtstoff durch Bestrahlung mit einer Anregungsquelle, die ultraviolettes Licht oder sichtbares Licht zwischen und einschließlich 100 nm und 550 nm oder Elektronenstrahlen aufweist, orangefarbene oder rote Fluoreszenz mit einer Wellenlänge zwischen und einschließlich 570 nm und 700 nm emittiert.

13. Leuchtstoff nach Anspruch 12, **dadurch gekennzeichnet, dass** der Leuchtstoff bei Bestrahlung durch die Anregungsquelle Fluoreszenz mit (x,y)-Werten in CIE-Farbartkoordinaten emittiert, die eine Bedingung $0,4 \leq x \leq 0,7$ erfüllen.

14. Verfahren zum Herstellen des Leuchtstoffs nach einem der Ansprüche 1 bis 13, **dadurch gekennzeichnet, dass** das Verfahren den folgenden Schritt aufweist:

   Brennen eines Ausgangsmaterialgemischs in einer Stickstoffatmosphäre bei einem Druck zwischen und einschließlich 0,1 MPa und 100 MPa in einem Temperaturbereich zwischen und einschließlich 1200°C und 2200°C, wobei das Ausgangsmaterialgemisch ein Gemisch aus Metallverbindungen ist und eine Zusammensetzung bilden kann, die M, A, Si, Al, O und N aufweist (M ist eine Art oder zwei oder mehr Arten von Elementen, ausgewählt unter Mn, Ce, Nd, Sm, Eu, Tb, Dy, Ho, Er, Tm und Yb; und A ist eine Art oder zwei oder mehr Arten von Elementen, ausgewählt unter Mg, Ca, Sr und Ba).

15. Leuchtgerät, das durch eine Lichtemissionsquelle und einen Leuchtstoff nach einem der Ansprüche 1 bis 13 gebildet wird.

16. Leuchtgerät nach Anspruch 15, **dadurch gekennzeichnet, dass** die Lichtemissionsquelle eine LED zur Emission von Licht bei einer Wellenlänge von 330 bis 500 nm ist.

17. Leuchtgerät nach Anspruch 15, **dadurch gekennzeichnet, dass** die Lichtemissionsquelle eine LED zur Emission von Licht bei einer Wellenlänge zwischen 330 und 420 nm ist; und
daß der Leuchtstoff ferner aufweist: einen Leuchtstoff mit blauem Zielspektrum, der ein Lichtemissionsmaximum bei einer Wellenlänge zwischen und einschließlich 420 nm und 500 nm aufweist; und einen Leuchtstoff mit grünem Zielspektrum, der ein Lichtemissionsmaximum bei einer Wellenlänge zwischen und einschließlich 500 nm und 570 nm aufweist.

18. Leuchtgerät nach Anspruch 15, **dadurch gekennzeichnet, dass** die Lichtemissionsquelle eine LED zur Emission von Licht bei einer Wellenlänge zwischen 420 und 500 nm ist; und
daß der Leuchtstoff ferner einen Leuchtstoff mit grünem Zielspektrum aufweist, der ein Lichtemissionsmaximum bei einer Wellenlänge zwischen und einschließlich 500 nm und 570 nm aufweist.

19. Leuchtgerät nach Anspruch 15, **dadurch gekennzeichnet, dass** die Lichtemissionsquelle eine LED zur Emission von Licht bei einer Wellenlänge zwischen 420 und 500 nm ist; und
daß der Leuchtstoff ferner einen Leuchtstoff mit gelbem Zielspektrum aufweist, der ein Lichtemissionsmaximum bei einer Wellenlänge zwischen und einschließlich 550 nm und 600 nm aufweist.

20. Bildanzeigevorrichtung, die aus einer Anregungsquelle und einem Leuchtstoff nach einem der Ansprüche 1 bis 13 besteht.

**Revendications**

1. Luminophore, **caractérisé en ce qu'**il comprend, à titre de composant principal, un composé inorganique comprenant :

   un cristal représenté par $A_2Si_{5-x}Al_xO_xN_{8-x}$ (où A est un mélange d'un type ou de deux types ou plus d'éléments choisis parmi Mg, Ca, Sr et Ba ; et x est une valeur comprise entre 0,05 et 0,8, bornes comprises) ; et
   un élément métallique M (M étant un type ou deux types ou plus d'éléments choisis parmi Mn, Ce, Nd, Sm, Eu, Tb, Dy, Ho, Er, Tm et Yb) dissous, à l'état solide, dans le cristal.

2. Luminophore selon la revendication 1, **caractérisé en ce que** x est une valeur comprise entre 0,05 et 0,5, bornes comprises.

3. Luminophore selon la revendication 1 ou 2, **caractérisé en ce que** le composé inorganique comprend un cristal sous la forme d'une solution solide représenté par $A_{2-y}Si_{5-x}Al_xO_xN_{8-x}:M_y$ et y est une valeur située dans la plage $0,001 \leq y \leq 0,5$.

**4.** Luminophore selon la revendication 1, **caractérisé en ce que** le composé inorganique comprend au moins Eu à titre d'élément métallique M.

**5.** Luminophore selon l'une quelconque des revendications 1 à 4, **caractérisé en ce que** l'élément M est Eu et l'élément métallique A est Sr ou Ca.

**6.** Luminophore selon l'une quelconque des revendications 1 à 4, **caractérisé en ce que** le composé inorganique comprend un cristal sous la forme d'une solution solide représenté par $Sr_aCa_bSi_{5-x}Al_xO_xN_{8-x}:Eu_y$, et les valeurs "a" et "b" sont situées à l'intérieur des plages respectivement définies par :

uminophore s

et

**7.** Luminophore selon l'une quelconque des revendications 1, à 6, **caractérisé en ce que** le composé inorganique est une poudre ayant une granulométrie moyenne comprise entre 0,1 $\mu$m et 20 $\mu$m, bornes comprises.

**8.** Luminophore selon la revendication 1, **caractérisé en ce qu'**il comprend en outre une phase amorphe ou une phase cristalline additionnelle, en plus du composé inorganique ; et **en ce que** le composé inorganique est présent en une proportion de 10 % en masse ou plus.

**9.** Luminophore selon la revendication 8, **caractérisé en ce que** la proportion du composé inorganique est de 50 % en masse ou plus.

**10.** Luminophore selon la revendication 8 ou 9, **caractérisé en ce que** la phase amorphe ou la phase cristalline additionnelle est une substance inorganique dotée d'une conductivité électrique.

**11.** Luminophore selon la revendication 10, **caractérisé en ce que** la substance inorganique dotée d'une conductivité électrique est un oxyde, un oxynitrure, un nitrure ou un de leurs mélanges comprenant un type ou deux types ou plus d'éléments choisis parmi Zn, Ga, In et Sn.

**12.** Luminophore selon l'une quelconque des revendications 1 à 11, **caractérisé en ce qu'**il émet une fluorescence orange ou rouge à une longueur d'onde comprise entre 570 nm et 700 nm, bornes comprises, par irradiation d'une source d'excitation comprenant une lumière ultraviolette ou une lumière visible entre 100 nm et 550 nm, bornes comprises, ou un faisceau d'électrons.

**13.** Luminophore selon la revendication 12, **caractérisé en ce qu'**il émet une fluorescence ayant des valeurs (x, y) sur les coordonnées de chromaticité CIE satisfaisant à la condition $0,4 \leq x \leq 0,7$ quand il est irradié par la source d'excitation.

**14.** Procédé de production du luminophore de l'une quelconque des revendications 1 à 13, **caractérisé en ce qu'**il comprend l'étape consistant à :

calciner un mélange de matériaux de départ dans une atmosphère d'azote sous une pression comprise entre 0,1 MPa et 100 MPa, bornes comprises, à une température située dans la plage comprise entre 1200°C et 2200°C, bornes comprises,
dans lequel le mélange de matériaux de départ est un mélange de composés métalliques et est capable de constituer une composition comprenant M, A, Si, Al, O et N (M étant un type ou deux types ou plus d'éléments choisis parmi Mn, Ce, Nd, Sm, Eu, Tb, Dy, Ho, Er, Tm et Yb ; et A étant un type ou deux types ou plus d'éléments choisis parmi Mg, Ca, Sr et Ba).

**15.** Instrument d'éclairage constitué d'une source d'émission de lumière et d'un luminophore selon l'une quelconque des revendications 1 à 13.

**16.** Instrument d'éclairage selon la revendication 15, **caractérisé en ce que** la source d'émission de lumière est une DEL pour émettre une lumière à une longueur d'onde de 330 à 500 nm.

**17.** Instrument d'éclairage selon la revendication 15, **caractérisé en ce que** la source d'émission de lumière est une DEL pour émettre une lumière à une longueur d'onde comprise entre 330 et 420 nm ; et **en ce que** le luminophore comprend en outre un luminophore donnant du bleu ayant un pic d'émission à une longueur d'onde comprise entre 420 nm et 500 nm, bornes comprises, par la lumière ; et un luminophore donnant du vert ayant un pic d'émission à une longueur d'onde comprise entre 500 nm et 570 nm, bornes comprises, par la lumière.

**18.** Instrument d'éclairage selon la revendication 15, **caractérisé en ce que** la source d'émission de lumière est une DEL pour émettre une lumière à une longueur d'onde comprise entre 420 et 500 nm ; et **en ce que** le luminophore comprend en outre un luminophore donnant du vert ayant un pic d'émission à une longueur d'onde comprise entre 500 nm et 570 nm, bornes comprises, par la lumière.

**19.** Instrument d'éclairage selon la revendication 15, **caractérisé en ce que** la source d'émission de lumière est une DEL pour émettre une lumière à une longueur d'onde comprise entre 420 et 500 nm ; et **en ce que** le luminophore comprend en outre un luminophore donnant du jaune ayant un pic d'émission à une longueur d'onde comprise entre 550 nm et 600 nm, bornes comprises, par la lumière.

**20.** Dispositif d'affichage d'image constitué d'une source d'excitation et d'un luminophore selon l'une quelconque des revendications 1 à 13.

Fig. 1

Fig. 2

Fig. 3

Fig. 4

Fig. 5

Fig. 6

Fig. 7

Fig. 8

## REFERENCES CITED IN THE DESCRIPTION

### Patent documents cited in the description

- US 6682663 B
- JP 2003206481 A
- US 6670748 B
- JP 2002322474 A
- JP 2003321675 A
- JP 2003277746 A
- JP 2004010786 A
- JP 2900928 B
- JP 2927279 B
- JP 3364229 B
- JP 10163535 A
- JP 2002363554 A
- JP 5152609 A
- JP 7099345 A

### Non-patent literature cited in the description

- **1: H. A. Hoppe.** *Journal of Physics and Chemistry of Solids,* 2000, vol. 61, 2001-2006
- **J. W. H. van Krevel.** *On new rare-earth doped M-Si-Al-O-N meterials,* 2000, ISBN 90-386-2711-4